# EUROPÄISCHE PATENTSCHRIFT

(11) **EP 2 673 869 B1**
(45) Veröffentlichungstag und Bekanntmachung des Hinweises auf die Patenterteilung: **06.04.2016**
(21) Anmeldenummer: 11804505.3
(22) Anmeldetag: 05.12.2011
(51) Int. Cl.: H02M 3/156

(54) **GLEICHSPANNUNGSWANDLER MIT SCHALTUNG ZUM NACHBILDEN EINES STROMS DURCH EINE SPEICHERDROSSEL**
DC-DC CONVERTER WITH CIRCUIT FOR REPRODUCING A CURRENT FLOWING THROUGH A STORAGE INDUCTOR
CONVERTISSEUR DE COURANT CONTINU COMPORTANT UN CIRCUIT DESTINÉ À RECONSTITUER UN COURANT AU MOYEN D'UNE INDUCTANCE DE STOCKAGE

(30) Priorität: 06.12.2010 DE 102010061042
(43) Veröffentlichungstag der Anmeldung: 18.12.2013
(73) Patentinhaber: Hella KGaA Hueck & Co, 59552 Lippstadt (DE)
(72) Erfinder: DAUB, Wolfgang, 59609 Anröchte (DE)
(86) Internationale Anmeldenummer: PCT/EP2011/071723
(87) Internationale Veröffentlichungsnummer: WO 2012/076457

(56) Entgegenhaltungen:
- US-A- 5 498 984
- US-A1- 2006 044 843
- US-A1- 2008 048 645
- US-A1- 2009 267 582
- US-A1- 2010 131 219

## Beschreibung

Die Erfindung betrifft eine Schaltung zum zumindest abschnittsweise Nachbilden eines Stroms durch eine Speicherdrossel eines Gleichspannungswandlers, insbesondere eines bidirektionalen Gleichspannungswandlers, zum Beispiel eines bidirektionalen Aufwärts-Abwärts-Wandlers, einem ersten Ein- und/oder Ausgang zur Verbindung mit einem ersten Netz und einem zweiten Ein- und/oder Ausgang zur Verbindung mit einem zweiten Netz.

Aus dem Dokument DE 696 34 709 T2 ist ein bidirektionaler Aufwärts-Abwärts-Wandler, der auch als "Buck-Boost"-Wandler bezeichnet wird bekannt. Bekannt ist auch eine Schaltung, mit der der Strom durch die Speicherdrossel des Schaltwandlers erfasst werden kann. Weitere herkömmliche Schaltungen und Methoden zur Stromer-fassung sind in dem Dokument erwähnt. In Dokument sind auch Probleme mit diesen bekannten Methoden und Schaltungen zur Erfassung des Stroms durch den Schaltwandler angesprochen.

Die herkömmlichen Schaltungen und Methoden beruhen auf zwei verschiedenen Prinzipien, nämlich der Erfassung des Stroms über einen Messwiderstand und der Erfassung des Stroms mittels eines Transformators und einem Messwiderstand in einem Sekundärkreis des Transformators.

Auch an dieser Stelle soll kurz auf die Nachteile der beiden Prinzipien eingegangen werden.

Bei der Verwendung eines Messwiderstandes können vorteilhaft nur Ströme mit Frequenzen sehr viel kleiner als die Grenzfrequenz fg=R/2pi*Lp gemessen werden, wobei Lp die parasitäre Induktivität des Messwiderstandes und R der Widerstand des Messwiderstandes ist. Bei großen Strömen werden niederohmige Messwiderstände benötigt, um Verlustleistungen klein zu halten. Das führt zu kleinen Grenzfrequenzen.

Gleichspannungswandler werden aber vorteilhaft Schaltfrequenzen aufweisen, auch Wandlerfrequenzen genannt, die im Bereich von 100 bis 1000 kHz liegen. Nur dann erhält man zufriedenstellende Wirkungsgrade und Baugrößen zu vertretbaren Kosten. Andernfalls sind teure Drosseln und aufwändige Filterelemente erforderlich, um den notwendigen Schutz vor elektromagnetischer Strahlung zu erreichen (EMV).

Die Frequenzabhängigkeit des Messwiderstandes kann zwar mit Filterschaltungen kompensiert werden, wenn die parasitäre Induktivität bekannt ist und von den Herstellern spezifiziert werden. Das ist in der Regel nicht der Fall. Eine Kompensation kommt daher in der Regel nicht in Frage.

Alternativ könnte man, um hohe Grenzfrequenzen zu erreichen, hochohmige Messwiderstände verwenden. Das hat aber hohe Verlustleistungen zur Folge. Eine zusätzliche Kühlung ist dann ebenfalls erforderlich.

Die Messung des Stroms mittels eines Transformators und einem Messwiderstand im Sekundärkreis, die insbesondere auch im bereits genannten Dokument DE 696 34 709 T2 offenbart ist, macht die Anschaffung eines teuren Transformators notwendig.

Aus dem Datenblatt "LM5116 Wide Range Synchronous Buck Controller" vom 8. Dezember 2008, herausgegeben von der National Semiconductor Corporation ist eine Schaltung bekannt (Seite 11 des Datenblattes), mit der der Strom durch eine Speicherdrossel eines Gleichspannungswandlers, es handlet sich um einen Sychronwandler, nicht gemessen sondern nachgebildet wird. Im Gleichspannungswandler ist ein Messwidestand angeordnet, der zumindest zeitweise in Reihe zu der Speicherdrossel liegt und über den dann der Spulenstrom geführt wird. Von der über dem Messwiderstand abfallenden Spannung wird mittel eines Haltegliedes der Gleichspannungsanteil erfasst. Der Wechselanteil des Spulenstroms wird dagegen aus eine Spannungsdifferenz aus der Spannung am Eingang und der Spannung am Ausgang des Gleichspannungswandlers hergeleitet.

### Die Schaltung umfasst somit

- erste Mittel zum Erzeugen eines ersten Signals, das einen Gleichanteil des Stroms durch die Speicherdrossel erfasst, wobei das erste Mittel erste Elemente zum Erzeugen des ersten Signals umfasst,
- zweite Mittel zum Erzeugen eines zweiten Signals, das den Wechselanteil des Stroms durch die Speicherdrossel nachbildet, und
- dritte Mittel zum Zusammenfügen des ersten Signals und des zweiten Signals zu einem den Strom durch die Speicherdrossel zumindest abschnittsweise nachbildenden Signal.

Die Erfassung des Gleichanteils des Stroms durch die Speicherdrossel mittels des Messwiderstands an der auf der Seite 11 des genannten Datenblatts angegebenen Stelle hat folgenden Nachteil:
Der Messwiderstand, in der Abbildung auf der Seite 11 des Datenblatt mit Rₛ bezeichnet, hat (vereinfacht gesehen) eine parasitäre Längsinduktivität und eine parasitäre Parallelkapazität. Er bildet einen Schwingkreis, welcher mit dem diskontinuierlichen Stromsignal angeregt wird. Wird der in der Abbildung auf der Seite 11 des Datenblatt mit Q1 bezeichnete MOSFET abgeschaltet, führt dies dazu, dass die Spannung am Knoten SW, an dem die Speicherdrossel L1 mit den beiden MOSFET Q1, Q2 verbunden ist, umschwingt und negativer als das untere Potential wird. Jetzt wird der MOSFET Q2 zwangsgeschaltet (die parasitäre Paralleldiode des MOSFET Q2 wird leitend). Das Signal am Messwiderstand wird gemäß der endlichen Schaltzeiten der MOSFET, der MOSFET-Kapazitäten, der Einschaltverzögerung des MOSFETs Q2, der Speicherwirkung der unteren Parasitärdiode des MOSFETs Q2, der nicht idealen Speicherdrossel L1 sowie der eigenen parasitären Elemente des Messwiderstands Rₛ ein Einschwingverhalten zeigen. Die Amplitude dieses Einschwingverhaltens kann ein vielfaches des gewünschten Nutzsignales betragen. Der Wirkwiderstand des Messwiderstands Rₛ muss daher möglichst groß gewählt werden, damit sich ein brauchbares Signal-Störverhältnis ergibt. Das Abtasten des Signals mit einer Abtast-Halteschaltung wird bei kleinen Widerstandswerten immer schwieriger, weil das Abtasten eine gewisse Zeit dauert. In dieser Zeit sollte sich das abzutastende Signal nicht ändern. Außderdem dauert bei höheren Wandlerfrequenzen das Einschwingverhalten länger als die Zeit die der MOSFET Q2 leitend ist. Auch dann ist das abgetastete Signal unbrauchbar.

Der Erfindung liegt die Aufgabe zugrunde diese Schaltung so zu verbessern, dass keine oder niederohmige Messwiderstände benutzt werden können, hohe Wandlerfrequenzen verwendet werden können, auf Filterschaltungen zur Kompensation von parasitären Elementen des Messwiderstandes verzichtet werden kann und die Schaltung kostengünstig herstellbar ist.

US 2010/013 12 19 offenbart eine Schaltung zum Schätzen des Speicherdrosselstromes und seines Gileichanteils.

Die Aufgabe wird durch eine Schaltung gemäß dem Anspruch 1 bzw. eine Schaltungs anordnung gemäß dem Anspruch 10 gelöst. Die ersten Elemente des ersten Mittels umfassen demgemäß einen Messwiderstand, wobei der Messwiderstand einerseits mit der Speicherdrossel und einem ersten Kondensator und andererseits mit dem erste Ein- und Ausgang verbunden ist.

Anstelle einer Messung des Stroms durch die Speicherdrossel wird aus anderen, mit einfachen Mitteln erfassbaren elektrischen Größen mittels der erfindungsgemäßen Schaltung der Strom durch die Speicherdrossel nachgebildet. Diese Nachbildung des Stroms durch die Speicherdrossel ist in vielen Fällen von so guter Qualität, so dass eine genaue Messung des Stroms mit allen damit verbundenen Nachteilen unterbleiben kann. So entspricht die Nachbildung nur abschnittsweise dem tatsächlichen Drosselstrom, wobei die Nachbildung des Drosselstroms in den für die Weiterverarbeitung bedeutenden Abschnitten korrekt nachgebildet wird.

Einer Ausgestaltung der ersten Mittel zum Erzeugen des ersten Signals, das den Gleichanteil des Stroms durch die Speicherdrossel erfasst, liegen folgende hervorzuhebende Überlegungen zugrunde.

Anstelle der Nutzung eines Messwiderstandes zum Erfassen des vollständigen Stroms durch die Speicherdrossel wird der Messwiderstand nur dafür genutzt den Gleichanteil des Stroms durch die Speicherdrossel zu messen und den gemessenen Strom in das erste, dem Strom entsprechende Signal umzuformen. Eine Erfassung des Wechselanteils des Stroms durch die Speicherdrossel mittels des Messwiderstandes ist nicht notwendig. Die sich bei der Messung des Wechselanteils üblicher weise ergebenden Probleme können umgangen werden. Der Gleichanteil des Stroms wird vorzugsweise an einer Stelle gemessen, an der vorzugsweise nur ein Gleichstrom fließt. Das kann zum Beispiel der Strom durch den ersten Ein- und/oder Ausgang sein.

Auf der Grundlage dieser Überlegungen zur Ausgestaltung der ersten Mittel zum Erzeugen der den Gleichanteil des Stroms durch die Speicherdrossel entsprechenden ersten Spannung, werden die ersten Elemente zum Erzeugen des ersten Signals vorgeschlagen, die einen Mittelwert des Stroms durch die Speicherdrossel, also den Gleichanteil erfassen. Aus dem erfassten Strom wird das erste Signal erzeugt, das dem Gleichanteil des Stroms durch die Speicherdrossel entspricht. Diese ersten Elemente sind Teil der ersten Mittel zum Erzeugen des ersten Signals.

Die ersten Elemente des ersten Mittels weisen zwei antiparallel geschaltete Transkonduktanzverstärker auf, deren Eingängen die über einen Messwiderstand abfallende Spannung zugeführt ist. Durch den Messwiderstand fließt der mittels des Messwiderstands und eines Kondensators gefilterte Gleichanteil des Stroms durch die Speicherdrossel. Die Spannung über dem Messwiderstand, der eines der ersten Elemente des ersten Mittels zum Erzeugen des ersten Signals sein kann, kann durch einen der beiden Transkonduktanzverstärker in einen Strom gewandelt werden. Welcher der beiden Transkonduktanzverstärker die Spannung in den Strom wandelt, hängt dabei davon ab, in welcher Richtung der Strom durch den Messwiderstand fließt. Der Ausgangsstrom des bzw. der Transkonduktanzverstärker kann über eine Parallelschaltung aus einem Widerstand und einem Kondensator zur Masse geführt werden. Durch den Kondensator der Parallelschaltung kann der Strom geglättet werden. Durch den Widerstand ist eine Wandlung des durch den Kondensator geglätteten Stroms in eine Spannung möglich. Diese Spannung kann das erste Signal bilden, das dem Gleichstrom durch die Speicherdrossel entspricht.

Einer Ausgestaltung der zweiten Mittel zum Erzeugen des zweiten Signals, das den Wechselanteil des Stroms durch die Speicherdrossel erfasst, oder der Komponenten eines solchen zweiten Signals, liegen folgende hervorzuhebende Überlegungen zugrunde.

Das zweite, den Wechselanteil des Stroms durch die Speicherdrossel angebende Signal kann man gewinnen, in dem man ein Signal integriert, das die Spannung über der Speicherdrossel nachbildet, da bekanntlich die Spannung über einer Drossel der Ableitung des Stroms durch die Drossel entspricht (U=L**d*l/*d*t).

Die zweiten Mittel weisen daher vorteilhaft Elemente zum Erzeugen eines dritten Signals auf, das die Spannung über der Speicherdrossel nachbildet. Das dritte, die Spannung über der Speicherdrossel nachbildende Signal kann aus am ersten Ein- und/oder Ausgang des Gleichspannungswandlers und/oder am zweiten Ein- und/oder Ausgang des Gleichspannungswandlers anliegenden Spannungen gebildet werden. Das dritte Signal ist nicht das Ergebnis einer Messung der Spannung über der Speicherdrossel. Vielmehr werden einfach erfassbare elektrische Größen erfasst und benutzt um die Spannung über der Speicherdrossel nachzubilden.

Für viele Anwendungen ist es ausreichend, wenn nur die Spannung an der Drossel nachgebildet werden muss, die einen Anstieg des Drosselstromes bewirkt. Die Integration der Spannung über bestimmte periodisch sich wiederholende Zeitabschnitte ähnelt in den interessierenden Zeitbereichen einer Faltung. Dadurch, dass nur bestimmte Abschnitte des "gefalteten" Signals benötigt werden, können bestimmte Randparameter so eingestellt werden, dass
Offsetgrößen nach der Integration nicht zu einem "Weglaufen" des Signals führen.

Die Spannung über der Speicherdrossel des Gleichspannungswandlers kann, je nach dem ob durch den Gleichspannungswandler Energie vom ersten Ein- und/oder Ausgang zum zweiten Ein- und/oder Ausgang transportiert wird, entweder durch die Differenz der Spannungen zwischen dem ersten Ein- und/oder Ausgang und dem zweiten Ein- und/oder Ausgang oder durch die Spannung am ersten oder am zweiten Ein- und/oder Ausgang nachgebildet werden. Bei einem bidirektionalen Aufwärts-Abwärts Gleichspannungswandler wird die Spannung über der Speicherdrossel im Aufwärtsbetrieb durch die Spannung am ersten Ein- und/oder Ausgang nachgebildet, der dann die Funktion des Eingangs hat. Im Abwärtsbetrieb wird sie durch die Differenz der Spannungen zwischen dem ersten Ein- und/oder Ausgang und dem zweiten Ein- und/oder Ausgang nachgebildet, wobei dann der erste Ein- und/oder Ausgang die Funktion des Ausgangs und der zweite Ein- und/oder Ausgang die Funktion des Eingangs hat.

Die Elemente zum Erzeugen des dritten Signals, das die Spannung über der Speicherdrossel nachbildet, können einen ersten Operationsverstärker aufweisen, an dem die Spannung am ersten Ein- oder Ausgang anliegende Spannung anliegt, die im Aufwärtsbetrieb zur Erzeugung des dritten Signals genutzt wird. Der erste Operationsverstärker kann ein Spannungsfolger sein. Der Ausgang des ersten Operationsverstärkers ist vorzugsweise über ein erstes steuerbares Schaltelement mit einem ersten Knoten verbunden. Das erste steuerbare Schaltelement kann von einem Steuerungsmittel im Aufwärtsbetrieb des Gleichspannungswandlers zum Schließen angesteuert werden.

Die Elemente zum Erzeugen des dritten Signals können ferner einen zweiten Operationsverstärker aufweisen. Der zweite Operationsverstärker kann rückgekoppelt sein. Er kann als Differenzverstärker beschaltet sein. An den Eingängen des zweiten Operationsverstärkers liegen vorteilhaft die zum Erzeugen des dritten Signals im Abwärtsbetrieb genutzten und an dem ersten Ein- und/oder Ausgang und dem zweiten Ein- und/oder Ausgang anliegenden Spannungen an. Der Ausgang des zweiten Operationsverstärkers liefert das dritte Signal und ist vorzugsweise über ein zweites steuerbares Schaltelement mit dem ersten Knoten verbunden. Anstelle eines Differenzverstärkers kann auch ein anderer Subtrahierer eingesetzt werden, mit dem sich die Spannungen an den Ein- und/oder Ausgängen subtrahieren lassen. Das zweite steuerbare Schaltelement kann von einem Steuerungsmittel im Abwärtsbetrieb des Gleichspannungswandlers zum Schließen angesteuert werden.

Die zweiten Mittel können Elemente zum Integrieren des dritten Signals aufweisen, mit welchen ein viertes Signal erzeugbar ist. Die Elemente zum Integrieren können eine von dem dritten Signal steuerbare Stromquelle und in Reihe zur steuerbaren Stromquelle eine Parallelschaltung aus einem steuerbaren Schaltelement und einem Kondensator aufweisen. Dieses steuerbare Schaltelement kann von einem Steuerungsmittel so angesteuert werden, dass er bei steigendem Strom durch die Speicherdrossel geöffnet ist, so dass der Kondensator aufgeladen wird, und dass er bei fallendem Strom durch die Speicherdrossel geschlossen ist, um den Kondensator zu entladen. Die Spannung über dem Kondensator, die das vierte Signal bildet, kann nicht unmittelbar als zweites, den Wechselanteil des Stroms durch die Speicherdrossel nachbildendes Signal genutzt werden. Das vierte Signal bildet den um den Scheitelwert des Wechselanteils verschobenen Wert des Wechselanteils des Stroms durch Drosselspule nach. Aus diesem vierten Signal kann das den Wechselanteil nachbildende zweite Signal erzeugt werden, wenn man den Scheitelwert des Wechselanteils von dem vierten Signal abzieht.

Die zweiten Mittel umfassen daher Elemente zum Erzeugen eines fünften Signals, das den Scheitelwert des Wechselanteils des Strom durch die Speicherdrossel nachbildet. Das den Scheitelwert des Wechselanteils des Stroms durch die Speicherdrossel angebende fünfte Signal, kann man aus dem vierten Signal erzeugen, das durch die Integration gebildet worden ist. Die Elemente des zweiten Mittels zum Erzeugen des fünften Signals können dazu einen Detektor aufweisen, mit welchem die Schwingungsbreite des zweiten Signals detektiert wird. Ein von diesem Detektor erzeugbares Signal kann mittels eines Operationsverstärkers mit einem Verstärkungsfaktor von 0,5 halbiert werden, um dann als fünftes Signal, dass den Scheitelwert des Wechselanteils angibt, genutzt zu werden.

Die dritten Mittel zum Zusammenfügen des Wechselanteils und des Gleichanteils können dann Elemente zum Subtrahieren des fünften Signals von dem vierten Signal zum Erzeugen des zweiten Signals aufweisen. Das erste und das zweite Signal kann dann durch ein Element zum Addieren addiert werden, um dass den Strom durch die Speicherdrossel nachbildende Signal zu erzeugen.

Alternativ und bevorzugt kann auch zunächst das fünfte Signal, das eine erste Komponente des zweiten Signals bildet, von dem ersten Signal mittels eines Subtrahierer der dritten Mittel subtrahiert werden, um ein Hilfssignal zu erzeugen. Das Hilfssignal wird anschließend mit mittels eines Addierers der dritten Mittel mit dem vierten Signal das eine zweite Komponente des zweiten Signals bildet, zusammengefasst, um das den Strom nachbildende Signal zu erzeugen. In diesem Fall muss dass zweite Signal selbst nicht gebildet werden.
In einer alternativen Schaltung wird ein siebtes Signal erzeugt, indem mittels eines Kondensators in Reihe zum vierten Signal der Gleichanteil vom vierten Signal abgetrennt wird. Das siebte Signal ist also der Wechselanteil vom vierten Signal.

Das erste und siebte Signal werden passiv addiert, indem sie über zwei (gleiche) Widerstände mit einem Knoten verbunden werden. Die Spannung am Knoten ist abschnittsweise proportional zum Drosselstrom. Das siebte Signal ist zwar ein bipolares Signal, es wird aber nur passiv weiterverarbeitet.

Ein Nachteil der alternativen Schaltung ist, dass die Schaltung eine Hochpasscharakteristik hat und zu Schwingneigung im geschlossenen Regelkreis führen kann. Möglicherweise lässt sie sich aber so dimensionieren, dass sie wie ein phasenanhebendes Glied wirkt, was eine stabilisierende Wirkung im geschlossenen Regelkreis zur Folge hätte.

Anhand der beigefügten Zeichnung wird die Erfindung nachfolgend näher erläutert. Dabei zeigt:

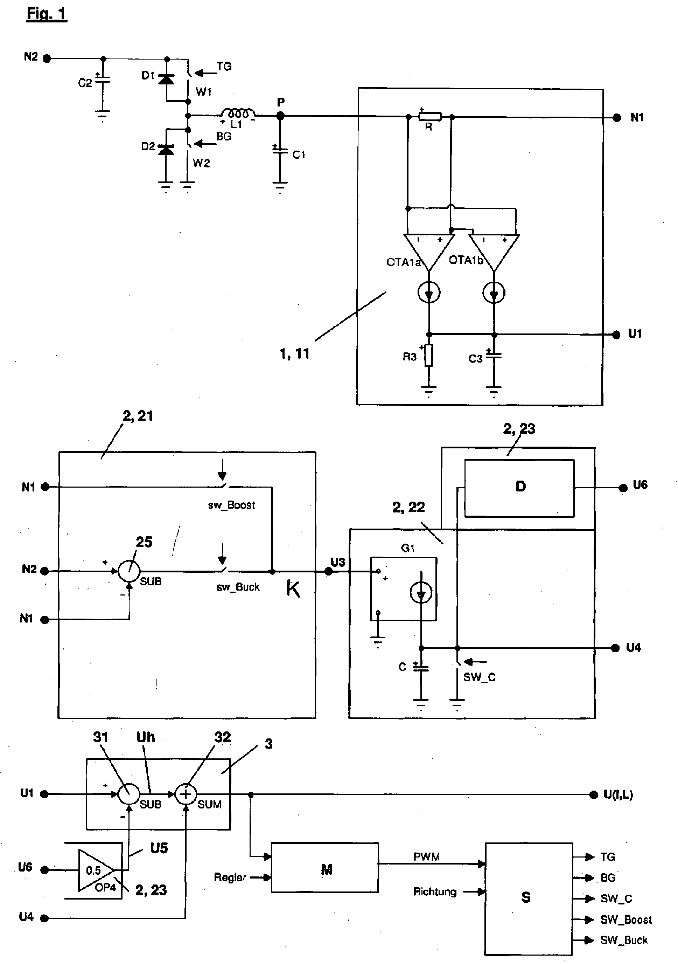

- Fig. 1: eine erfindungsgemäße Schaltungsanordnung mit einem bidirektionalen Aufwärts-Abwärts Gleichspannungswandler und einer erfindungsgemäßen Schaltung zum Nachbilden eines Stroms durch eine Speicherdrossel des

### Gleichspannungswandlers.

Die in der Figur 1 dargestellte erfindungsgemäße Schaltungsanordnung umfasst in einem Leistungsteil einen bidirektionalen Aufwärts-Abwärts Gleichspannungswandler. In diesem Leistungsteil bzw. in dem Gleichspannungswandler wird eine Spannung eines ersten Netzes in die Spannung eines zweiten Netzes umgewandelt oder umgekehrt die Spannung des zweiten Netzes in die Spannung des ersten Netzes umgewandelt. Der Energiefluss kann durch eine entsprechende Ansteuerung von steuerbaren Schaltelementen W1, W2 des Gleichspannungswandlers gesteuert werden. Neben den steuerbaren Schaltelementen W1, W2 umfasst der Gleichspannungswandler in bekannter Anordnung parallel zu den Schaltelementen angeordnete Dioden D1, D2, einen ersten Kondensator C1, eine Speicherdrossel L1 und einen zweiten Kondensator C2. An einem ersten Ein- und Ausgang N1 kann eine Spannung gegenüber Masse anliegen ebenso wie an einem zweiten Ein- und Ausgangs N2. Der erste Ein- und Ausgang N1 ist über einen Messwiderstand R mit einem Knoten P zwischen der Speicherdrossel L1 und dem ersten Kondensator C1 verbunden.

Die Steuerung der steuerbaren Schaltelemente W1, W2 erfolgt durch ein Steuerungsmittel S.

Der bidirektionale Aufwärts-Abwärts Gleichspannungswandler kann auf bekannte Art und Weise betrieben werden, um Energie von dem ersten Netz zum zweiten Netz und umgekehrt zu übertragen.

Die Schaltungsanordnung umfasst neben dem Leistungsteil, d.h. dem Gleichspannungswandler, eine Schaltung, mit welcher der Strom durch die Speicherdrossel L1 des Gleichspannungswandlers abschnittsweise nachgebildet werden kann.

Die Schaltung umfasst erste Mittel 1 zum abschnittsweisen Nachbilden eines Gleichanteils des durch die Speicherdrossel L1 fließenden Stroms. Neben diesen ersten Mitteln 1 umfasst die Schaltung zweite Mittel 2 zum Nachbilden eines Wechselanteils des durch die Speicherdrossel L1 fließenden Stroms.

Die ersten Mittel 1 umfassen erste Elemente 11 zum Erzeugen des ersten Signal, das dem gemessenen Gleichanteil des Stroms durch die Speicherdrossel L1 dentspricht. Die ersten Elemente 11 umfassen dazu zwei antiparallel geschaltete Transkonduktanzverstärker OTA1 a, OTA1b, deren Eingängen die über dem Messwiderstand R abfallende Spannung zugeführt ist. Je nach Stromrichtung des durch den Messwider stand R fließenden Stroms wird durch den einen oder durch den anderen Transkonduktanzverstärker OTA1a, OTA1b ein Strom erzeugt, der durch eine Parallelschaltung aus einem Kondensator C3 und einem Widerstand R3 geglättet und in eine Spannung gewandelt wird. Die über dieser Parallelschaltung abfallende Spannung wird als erstes Signal U1 zur Verfügung gestellt.

Der Wechselanteil des durch die Speicherdrossel L1 fließenden Stroms wird folgendermaßen durch die zweiten Mittel 2 gebildet:
Zunächst wird mit Elementen 21 zum Nachbilden der über der Speicherdrossel L1 abfallenden Spannung ein Spannungssignal U3, nämlich dem dritten Signal die über der Speicherdrossel L1 abfallende Spannung nachgebildet. Diese Elemente umfassen ein steuerbares Schaltelement sw_Boost, welches von dem Steuermittel S im Aufwärtsbetrieb des Gleichspannungswandlers geschlossen ist. Die Spannung am ersten Ein- und/oder Ausgang steht dann an einem Knoten K der Schaltung als drittes Signal U3 zur Verfügung.

Die Elemente zum Nachbilden der über der Speicherdrossel L1 abfallenden Spannung umfassen einen Subtrahierer 25, der die Spannung am ersten Ein- und/oder Ausgang N1 von der Spannung am zweiten Ein- und/oder Ausgang N2 abzieht. Der Ausgang des Subtrahierers 25 ist über ein steuerbares Schaltelement sw_Buck mit dem Knoten K verbunden. Das steuerbare Schaltelement sw_Buck wird im Abwärtsbetrieb des Gleichspannungswandlers vom Steuermittel S zum Schließen angesteuert. Die Ausgangspannung des Subtrahierers 25 steht dann als drittes Signal U3 am Knoten K an.

Das dritte Signal U3 wird mit Elementen 22 zum Integrieren integriert um ein viertes Signal zu erzeugen. Das dritte Signal U3 steuert dazu eine steuerbare Stromquelle G1, deren Strom über eine Parallelschaltung aus einem Kondensator C und einem weiteren steuerbaren Schaltelement SW_C geführt wird. Je nachdem, ob der Strom durch die Speicherdrossel 1 steigt oder fällt, wird der Kondensator C entweder bei geöffnetem steuerbaren Schaltelement SW_C aufgeladen oder über das geschlossene steuerbare Schaltelement SW_C entladen. Das Öffnen und Schließen des Schaltelementes SW_C erfolgt synchron zum Schalten der Schaltelemente W1 und W2 des Gleichspannungswandlers. Die Spannung über dem Kondensator C bildet das vierte Signal U4, welches einen um den Scheitelwert des Wechselanteils verschobenen Wechselanteil des Stroms durch die Speicherdrossel L1 nachbildet.

Mittels eines Detektors D zum Detektieren der Schwingungsbreite wird aus dem vierten Signal U4 ein sechstes Signal U6 erzeugt, welches die Schwingungsbreite des vierten Signals angibt. Mittels eines Operationsverstärkers OP4 wird die Schwingungsbreite halbiert, um so den Scheitelwert zu erhalten, der durch das fünfte Signal U5 bereitgestellt ist.

Das erste Signal U1, das vierte Signal und das fünfte Signal U5 werden mittels eines Mittels 3 zum Zusammenfügen zu dem gesuchten, den Strom durch die Speicherdrossel nachbildenden Signal U(I_L) zusammengefügt. Dabei wird durch einen Subtrahierer 31 des Mittels zum Zusammenfügen zunächst eine Hilfsgröße Uh durch Subtraktion des fünften Signals U5 von dem ersten Signal U1 abgezogen. Die Hilfsgröße wird dann mit dem vierten Signal U4 addiert und die Summe des vierten Signals U4 und des Hilfssignals Uh bildet das Signal U(I_L), welches den Strom durch die Speicherdrossel L1 nachbildet.

Das Steuermittel S hat vorzugsweise einen Eingang, welcher die Richtung der Energieübertragung durch den Gleichspannungswandler anzeigt. Außerdem kann das Steuermittel S einen Eingang aufweisen, über den dem Steuermittel ein plusweitenmoduliertes Signal PWM zugeführt wird. Dieses Signal PWM kann von einem PW-Modulator M aus dem den Strom durch die Speicherdrossel L1 nachblendenden Signal U (I_L) und einem Reglersignal erzeugt werden.

### Bezugszeichenliste

- N1: erste Ein- und Ausgang des Gleichspannungswandlers
- N2: zweiter Ein- und Ausgang des Gleichspannungswandlers

- C1: N1-seitiger Kondensator des Gleichspannungswandlers
- C2: N2-seitiger Kondensator des Gleichspannungswandlers

- D1: Diode des Gleichspannungswandlers
- D2: Diode des Gleichspannungswandlers
- W1: steuerbares Schaltelement des Gleichspannungswandlers
- W2: steuerbares Schaltelement des Gleichspannungswandlers

- L1: Speicherdrossel des Gleichspannungswandlers

- R: Messwiderstand
- OTA1a, OTA1b: Transkonduktanzveratärker
- R3: Widerstand zur Strom-Spannungs-Wandlung
- C3: Glättungskondensator

- sw_Boost, sw_Buck: steuerbare Schaltelemente
- P: Knoten des Gleichspannungswandlers

- G1: steuerbare Stromquelle
- C: Integratorkondensator
- SW_C: Steuerbare Schaltelement

- D: Detektor zum Detektieren der Schwingungsbreite
- OP4: Operationsverstärker zum Erzeugen des Scheitelwerts

- 1: erste Mittel zum Erzeugen des ersten Signals U1
- 11: erste Elemente des ersten Mittels zum Erzeugen des dritten Signals U3

- 2: zweites Mittel zum Erzeugen des zweiten Signals U2 oder zum Erzeugen von Komponenten des zweiten Signals U2
- 21: Elemente des zweiten Mittels zum Erzeugen des dritten Signals U3
- 22: Elemente des zweiten Mittels zum Integrieren und Erzeugen des vierten Signals U4
- 23: Elemente des zweiten Mittels zum Erzeugen des fünften Signals U5
- K: erste Knoten in den Elementen des zweiten Mittels zum Erzeugen des dritten Signals U3

- 3: Mittel zum Zusammenfügen des Gleichanteils (erstes Signal U1) und des Wechselanteils (zweite Signal U2) bzw. des ersten Signals U1 und der Komponenten des zweiten Signals U2
- 31: Subtrahierer
- 32: Addierer

- U1 bis U5: erstes bis fünftes Signal
- Uh: Hilfssignal
- S: Steuermittel
- M: PWM-Modulator

## Patentansprüche

1. Schaltung zum zumindest abschnittsweise Nachbilden eines Stroms durch eine Speicherdrossel (L1) eines Gleichspannungswandlers, insbesondere eines bidirektionalen Gleichspannungswandlers, zum Beispiel eines bidirektionalen Aufinrärts-Abwärts-Wandlers, mit einem ersten Ein- und/oder Ausgang (N1) zur Verbindung mit einem ersten Netz und mit einem zweiten Ein- und/oder Ausgang (N2) zur Verbindung mit einem zweiten Netz, wobei die Schaltung
- ein erstes Mittel (1) zum Erzeugen eines ersten Signals (U1) umfasst, das einen Gleichanteil des Stroms durch die Speicherdrossel (L1) erfasst oder nachbildet, wobei das erste Mittel (1) erste Elemente (11) zum Erzeugen des ersten Signals (U1) umfasst,
- eine zweites Mittel (2) zum Erzeugen eines zweiten Signals oder von Komponenten des zweiten Signals umfasst, das den Wechselanteil des Stroms durch die Speicherdrossel (L1) nachbildet, und
- dritte Mittel (3) zum Zusammenfügen des ersten Signals (U1) und des zweiten Signals bzw. des ersten Signals (U1) und der Komponenten des zweiten Signals zu einem den Strom durch die Speicherdrossel zumindest abschnittsweise nachbildenden Signal (U(I_L)) umfasst,
**dadurch gekennzeichnet, dass**
die ersten Elemente (11) des ersten Mittels (1) einen Messwiderstand (R) umfassen, wobei der Messwiderstand (R) einerseits mit der Speicherdrossel (L1) und einem ersten Kondensator (C1) und andererseits mit dem ersten Ein- und Ausgang (N1) verbunden ist.

2. Schaltung nach Anspruch 1, **dadurch gekennzeichnet, dass** die ersten Elemente (11) des ersten Mittels (1) zwei antiparallel geschaltete Transkonduktanzverstärker (OTA1a, OTA1b) aufweisen, denen eine über dem Messwiderstand (R) abfallende Spannung zugeführt ist.

3. Schaltung nach Anspruch 2, **dadurch gekennzeichnet, dass** die Ausgänge der Transkonduktanzverstärker (OTA1a, OTA1 b) über ein oder mehrere Wandlungselemente (R3, C3) in eine Spannung wandelbar sind, wobei diese Spannung als erstes Signal (U1) an dem oder den Wandlungselementen (R3, C3) abgreifbar ist.

4. Schaltung nach einem der Ansprüche 1 bis 3, **dadurch gekennzeichnet, dass** die zweiten Mittel (2) zweite Elemente (21) zum Erzeugen eines dritten Signals (U3) aus am ersten Ein- und/oder Ausgang (N1) und/oder am zweiten Ein- und/oder Ausgang (N2) anliegenden Spannungen aufweist.

5. Schaltung nach Anspruch 4, **dadurch gekennzeichnet, dass** die zweiten Elemente (21) so ansteuerbar sind, dass in einem Aufwärtswärtsbetrieb das dritte Signal (U3) aus einer am ersten Ein- und/oder Ausgang (N1) anliegenden Spannung erzeugbar ist und/oder in einem Abwärtsbetrieb das dritte Signal (U3) aus einer Differenz der Spannungen zwischen dem ersten Ein- und/oder Ausgang (N1) und dem zweiten Ein- und/oder Ausgang (N2) erzeugbar ist.

6. Schaltung nach Anspruch 4, **dadurch gekennzeichnet, dass** die zweiten Mittel (2) dritte Elemente (22) zum Integrieren des dritten Signals (U3) aufweist, mit welchen ein viertes Signal (U4) erzeugbar ist.

7. Schaltung nach Anspruch 6, **dadurch gekennzeichnet, dass** die zweiten Mittel (2) vierte Elemente (23) zum Erzeugen eines fünften Signals (U5) aus dem vierten Signal (U4) umfassen, das einen Scheitelwert des Wechselanteils des Stroms durch die Speicherdrossel (L1) nachbildet.

8. Schaltung nach Anspruch 7, **dadurch gekennzeichnet, dass** die dritten Mittel (3) fünfte Elemente (31) zum Subtrahieren des fünften Signals (U5) von dem ersten Signal (U1) zum Erzeugen eines Hilfssignals (Uh) aufweisen.

9. Schaltung nach einem der Ansprüche 6 bis 8, **dadurch gekennzeichnet, dass** die dritten Elemente (22) eine von dem dritten Signal (U3) steuerbare Stromquelle (G1) und in Reihe zur steuerbaren Stromquelle (G1) eine Parallelschaltung aus einem steuerbaren Schaltelement (SW_C) und einem Kondensator (C) aufweisen.

10. Schaltungsanordnung aus einem Gleichspannungswandler, insbesondere einem bidirektionalen Gleichspannungswandler, zum Beispiel einem bidirektionalen Aufinrärts-Abwärts-Wandler, und einer Schaltung zum Nachbilden eines Stroms durch eine Speicherdrossel (L1) des Gleichspannungswandlers,
**dadurch gekennzeichnet, dass**
die Schaltung zum Nachbilden des Stroms nach einem der Ansprüche 1 bis 9 ausgebildet ist.

## Claims

1. A circuit for the at least partial replication of a current by a choke (L1) of a DC-DC converter, in particular of a bi-directional DC-DC converter, for example of a bidirectional buck-boost converter, having a first input and / or output (N1) for the connection to a first network and having a second input and / or output (N2) for the connection to a second network, wherein the circuit comprises
a first means (1) for the generation of a first signal (U1) which detects or replicates a DC component of the current by means of the choke (L1), wherein the first means (1) comprises first elements (11) for the generation of the first signal (U1),
a second means (2) for the generation of a second signal or of components of said second signal replicating the AC component of the current by means of the choke (L1), and
third means (3) for joining the first signal (U1) and the second signal, respectively the first signal (U1) and the components of the second signal to a signal (U (I_L)) replicating at least sections of the current by means of the choke,
**characterized in that**
the first elements (11) of the first means (1) comprise a measuring resistor (R), wherein the measuring resistor (R) is on one hand connected to the choke (L1) and a first capacitor (C1) and on the other hand to the first in- and output (N1).

2. A circuit according to claim 1, **characterized in that** the first elements (11) of the first means (1) comprise two antiparallel-connected transconductance amplifiers (OTA1a, OTA1b), which are supplied with a voltage dropping across the measuring resistor (R)

3. A circuit according to claim 2, **characterized in that** the outputs of the transconductance amplifier (OTA1a, OTA1b) can be converted into a voltage via one or more conversion elements (R3, C3), wherein this voltage is available as a first signal (U1) at one or several conversion elements (R3, C3).

4. A circuit according to one of claims 1 to 3, **characterized in that** the second means (2) comprise second elements (21) for the generation of a third signal (U3) from voltages present at the first in- and/or output (N1) and /or at the second input and / or output (N2)

5. A circuit according to claim 4, **characterized in that** the second elements (2) are controllable so that in a boost operation, the third signal (U3) can be generated from a voltage available at the first input and / or output (N1) and / or in a buck-operation, the third signal (U3) can be generated from a difference between the voltages of the first input and / or output (N1) and the second input and / or output (N2).

6. A circuit according to claim 4, **characterized in that** the second means (2) comprises third elements (22) for the integration of the third signal (U3), with which a fourth signal (U4) can be generated.

7. A circuit according to claim 6, **characterized in that** the second means (2) comprise fourth elements (23) for the generation of a fifth signal (U5) from the fourth signal (U4), which replicates a peak value of the AC component of the current by means of the choke (L1).

8. A circuit according to claim 7, **characterized in that** the third means (3) comprise fifth elements (31) for subtracting the fifth signal (U5) from the first signal (U1) to generate an auxiliary signal (Uh).

9. A circuit according to one of claims 6 to 8, **characterized in that** the third elements (22) comprise a current source (G1) controllable by the third signal (U3) and a parallel circuit consisting of a controllable switching element (SW_C) and a capacitor (C) switched in series with the controllable current source (G1).

10. Circuit arrangement comprising a DC-DC converter, in particular a bi-directional DC-DC converter, for example, a bidirectional buck-boost converter, and a circuit for the replication of a current by means of a choke (L1) of the DC-DC converter,
**characterized in that**
the circuit for the replication of the current is embodied according to one of claims 1 to 9.

## Revendications

1. Circuit destiné à reconstituer au moins partiellement un courant au moyen d'une inductance de stockage (L1) d'un convertisseur de courant continu, surtout d'un convertisseur de courant continu bidirectionnel, par exemple d'un convertisseur élévateur-abaisseur bidirectionnel, avec une première entrée et/ou sortie (N1) pour la connexion avec un premier réseau et avec une deuxième entrée et/ou sortie (N2) pour la connexion avec un deuxième réseau, le circuit comprenant
- un premier moyen (1) destiné à générer un premier signal (U1) qui saisit ou reconstitue par l'inductance de stockage (L1) une composante continue du courant, le premier moyen (1) comprenant de premiers éléments (11) destinés à générer le premier signal (U1),
- un deuxième moyen (2) destiné à générer un deuxième signal ou des composantes du deuxième signal qui reconstitue par l'inductance de stockage (L1) la composante alternative du courant, et
- des troisièmes moyens (3) destinés à assembler le premier signal (U1) et le deuxième signal voire le premier signal (U1) et les composantes du deuxième signal pour obtenir un signal (U(I_L)) qui reconstitue au moins partiellement le courant circulant dans l'inductance de stockage,
**caractérisé en ce que**
les premiers éléments (11) du premier moyen (1) comprennent une résistance de mesure (R), la résistance de mesure (R) étant reliée, d'un côté, à l'inductance de stockage (L1) et à un premier condensateur (C1) et, de l'autre côté, à la première entrée et sortie (N1).

2. Circuit selon la revendication 1, **caractérisé en ce que** les premiers éléments (11) du premier moyen (1) présentent deux amplificateurs à transconductance (OTA1a, OTA1b) antiparallèles auxquels une chute de tension sur la résistance de mesure (R) est amenée.

3. Circuit selon la revendication 2, **caractérisé en ce que** les sorties des amplificateurs à transconductance (OTA1a, OTA1b) sont convertibles en une tension au moyen d'un ou de plusieurs éléments de conversion (R3,C3), cette tension pouvant être prélevée en tant que premier signal (U1) à l'élément de conversion ou aux éléments de conversion (R3, C3).

4. Circuit selon l'une des revendications 1 à 3, **caractérisé en ce que** les deuxièmes moyens (2) présentent des deuxièmes éléments (21) pour générer un troisième signal (U3) à partir des tensions appliquées sur la première entrée et/ou sortie (N1) et/ou sur la deuxième entrée et/ou sortie (N2).

5. Circuit selon la revendication 4, **caractérisé en ce que** les deuxièmes éléments (21) peuvent être commandés de telle manière que dans un fonctionnement élévateur le troisième signal (U3) puisse être généré d'une tension appliquée à la première entrée et/ou sortie (N1) et/ou dans un fonctionnement abaisseur le troisième signal (U3) puisse être généré d'une différence des tensions entre la première entrée et/ou sortie (N1) et la deuxième entrée et/ou sortie (N2).

6. Circuit selon la revendication 4, **caractérisé en ce que** les deuxièmes moyens (2) présentent des troisièmes éléments (22) pour intégrer le troisième signal (U3) avec lesquels un quatrième signal (U4) peut être généré.

7. Circuit selon la revendication 6, **caractérisé en ce que** les deuxièmes moyens (2) comprennent des quatrièmes éléments (23) pour générer un cinquième signal (U5) à partir du quatrième signal (U4) qui reconstitue par l'inductance de stockage (L1) une valeur de pointe de la composante alternative du courant.

8. Circuit selon la revendication 7, **caractérisé en ce que** les troisièmes moyens (3) présentent des cinquièmes éléments (31) pour soustraire le cinquième signal (U5) du premier signal (U1) pour générer un signal auxiliaire (Uh).

9. Circuit selon l'une des revendications 6 à 8, **caractérisé en ce que** les troisièmes éléments (22) présentent une source d'énergie (G1) contrôlable par le troisième signal (U3) et, en série par rapport à la source d'énergie contrôlable (G1), un circuit en parallèle comprenant un élément de commutation contrôlable (SW_C) et un condensateur (C).

10. Agencement de circuit d'un convertisseur de courant continu, surtout d'un convertisseur de courant continu bidirectionnel, par exemple d'un convertisseur élévateur-abaisseur bidirectionnel et d'un circuit destiné à reconstituer un courant au moyen d'une inductance de stockage (L1) du convertisseur de courant continu, **caractérisé en ce que** le circuit destiné à reconstituer le courant est réalisé selon l'une des revendications 1 à 9.
